# EUROPÄISCHE PATENTSCHRIFT

(11) **EP 0 545 394 B1**
(45) Veröffentlichungstag und Bekanntmachung des Hinweises auf die Patenterteilung: **24.09.1997**
(21) Anmeldenummer: 92120588.6
(22) Anmeldetag: 02.12.1992
(51) Int. Cl.: G01R 19/02, G01R 19/22, G01R 21/02

(54) **AC/DC Transfer-Technik zur Messung des Produktes von elektrischen Wechselgrössen**
AC/DC transfer-technique for measuring the product of alternating electric values
Technique de transfert AC/DC pour mesurer le produit des valeurs électriques alternatives

(30) Priorität: 02.12.1991 DE 4139619
(43) Veröffentlichungstag der Anmeldung: 09.06.1993
(73) Patentinhaber: DEUTSCHE ZAEHLER-GESELLSCHAFT Nachf. A. Stepper & Co. (GmbH & Co.), 22083 Hamburg (DE)
(72) Erfinder: Herrmann, Frank, Dipl.-Ing., W-3300 Braunschweig (DE); Stojanovic, Boris, YU-11000 Belgrad (YU)
(74) Vertreter: Richter, Werdermann & Gerbaulet

(56) Entgegenhaltungen:
- DE-A- 3 012 813
- DE-A- 3 143 669
- US-A- 3 273 059

## Beschreibung

Die Erfindung geht aus von einer Schaltungsanordnung zum Messen des zeitlichen Mittelwertes des Produktes zweier Wechselstromgrößen bzw. des Quadrates einer Wechselstromgrösse.

Solche Schaltungsanordnungen werden insbesondere zur Leistungsmessung in elektronischen Meßgeräten verwendet. Die AC/DC-Transfer-Technik stellt eine bekannte Möglichkeit dar, die Multiplikation bzw. Quadratbildung zweier Wechselgrößen zu vereinfachen. Bei einer bekannten Betriebsart sind die Wechselstromgrößen und eine Gleichstrom-Rückführungsgröße gleichzeitig mit den Eingängen eines Multiplizierers verbunden, und der Arbeitspunkt des Multiplizierers soll dabei etwa auf Null gehalten werden, wobei auch das Ausgangssignal, jedenfalls seine Gleichstromkomponente, zu Null wird.

Im allgemeinen wird das Ausgangssignal eines Multiplizierers durch interne Effekte, wie z.B. Offset und Temparatur, beeinflußt. Da vielfach gerade auch Wechselstromgrößen geringer Amplitude zuverlässig gemessen werden sollen, ergeben sich dadurch erhebliche Nachteile.

In der DE-A1-30 12 813 wird bei einer Anordnung zur Präzisionsmessung von Effektivwerten elektrischer (Wechsel-) Grössen eine Umsetzung des zu messenden Eingangssignals x(t) in ein anderes Signal x'(t) mittels einer Regelgrösse (v1) vorgenommen, um im nachfolgenden Quadrierer in demselben Arbeitspunkt arbeiten zu können, wie bei der vergleichenden Verarbeitung des konstanten Referenzsignals y. Die Umsetzung geschieht dabei durch Veränderung des Verstärkungsfaktors v1 einer Eingangsstufe 1.

Bei einer solchen Regelung über den Verstärkungsfaktor ist es nicht nur relativ aufwendig, die notwendige Konstanz in den Verstärkungseigenschaften und gegebenenfalls auch den gewünschten Frequenzgang zu erreichen, der für eine Präzisionsmessung bei verschiedenen Frequenzen notwendig ist. Es ist insbesondere ungünstig, eine solche Technik auf den Fall einer Produktbildung zweier unterschiedlicher Grössen zu übertragen, weil hier zweimal, d.h. in den beiden Eingangskanälen vor dem Produktbildner eine Verstärkungsregelung durchgeführt werden müsste, die nicht nur in jedem einzelnen Kanal präzise, sondern in beiden Kanälen auch noch möglichst identisch sein sollte.

Der Erfindung liegt die Aufgabe zugrunde, einen Produktbildner für Wechselstromleistungsmessung oder Effektivwertmessung so auszubilden, daß der Arbeitspunkt außerhalb des Nullpunktes gehalten und dementsprechend zuverlässig geregelt werden kann.

Diese Aufgabe wird durch die Gesamtheit der Merkmale des Anspruchs 1 gelöst.

Die Wechselstromgrößen, die Referenzgröße usw. können je nach dem Erfordernis der angeschlossenen Schaltung als Spannung und/oder Strom verarbeitet werden. Trotz des abwechselnden Betriebes des Produktbildners einerseits für Wechselstromgrößen und andererseits nur für eine Gleichstrom-Referenzgröße wird, vorzugsweise durch Speicherung und Summierung, eine kontinuierliche Gleichstrom-Regelgröße erhalten.

Da der Arbeitspunkt des Produktbildners bzw. der in ihm enthaltenen Verstärkerelemente ungleich Null gehalten wird und unabhängig von der Amplitude der Eingangswechselgrößen ist, sind Schwierigkeiten, die sonst in der Nähe des Nullpunktes auftreten können, vermieden. Die Regelgröße stellt gleichzeitig die Meßgrößen-Information dar.

Nach einer bevorzugten Ausführungsform dient als Produktbildner wenigstens ein Bauelement, das entsprechend dem Produkt der zugeführten Wechselstromgrössen erwärmt wird und ein Ausgangssignal abgibt, welches von der damit verbundenen Temperaturerhöhung abhängt.

Eine bevorzugte Weiterbildung dieser Ausführungsform zeichnet sich dadurch aus, dass der Produktbildner wenigstens einen ersten Transistor umfasst, dass zwischen dem Kollektor und dem Emitter des ersten Transistors eine Stromquelle angeordnet ist, deren Strom einerseits im ersten Intervall in Abhängigkeit von den mit der Regelgrösse kombinierten Wechselstromgrössen bzw. im zweiten Intervall von der Referenzgrösse gesteuert wird, dass zwischen Kollektor und Emitter des ersten Transistors eine Spannungsquelle angeordnet ist, deren Spannung andererseits im ersten Intervall in Abhängigkeit von den mit der Regelgrösse kombinierten Wechselstromgrössen bzw. im zweiten Intervall von der Referenzgrösse gesteuert wird, und dass die Basis-Emitter-Spannung des ersten Transistors das erste bzw. das zweite Gleichstrom-Ausgangssignal liefert. Dabei wird die Eigenschaft ausgenutzt, daß die Basis-Emitter-Spannung in einem bestimmten Arbeitspunkt infolge der Erwärmung von dem Effektivwert der zugeführten Signale abhängig ist und daß diese Erwärmung speichernd wirksam ist und daher auch kurz nach dem Wegfall einer Wechselstromgröße noch gemessen werden kann. Eine Speicherung über längere Zeit, z.B. über eines der Schalt-Intervalle, kann darüber hinaus in üblicher Weise mittels eines Kondensators vorgenommen werden.

Weitere Ausführungsformen ergeben sich aus den abhängigen Ansprüchen.

Die Erfindung wird nachstehend anhand der Zeichnung beispielsweise näher erläutert, in der
- F i g. 1: als Blockschaltbild das Prinzip der Erfindung darstellt,
- Fig. 2, 3 und 4: Ausführungsformen eines Produktbildners zeigen, in dem die Wärmeentwicklung in einem Transistor als Maß für die zugeführte Leistung ausgewertet wird,
- F i g. 5: eine Ausführungsform nach Fig.2 wiedergibt, in der die einzelnen Stufen des Produktbildners und der Erzeugung der Regelgröße näher angegeben sind,
- F i g. 6: ein Zeitdiagramm über die Betätigung der Umschalter in Fig.5 darstellt,
- Fig. 7: den Verlauf der Temparatur und damit der Basis-Emitterspannung in dem als Produktbildner wirkenden Transistor wiedergibt,
- Fig. 8: ein weiteres Detailschaltbild ist, und
- F i g. 9: eine Ausführungsform angibt, in der von einer Wechselspannung durch Quadrieren der Referenzwert bzw. der Effektivwert gebildet wird.

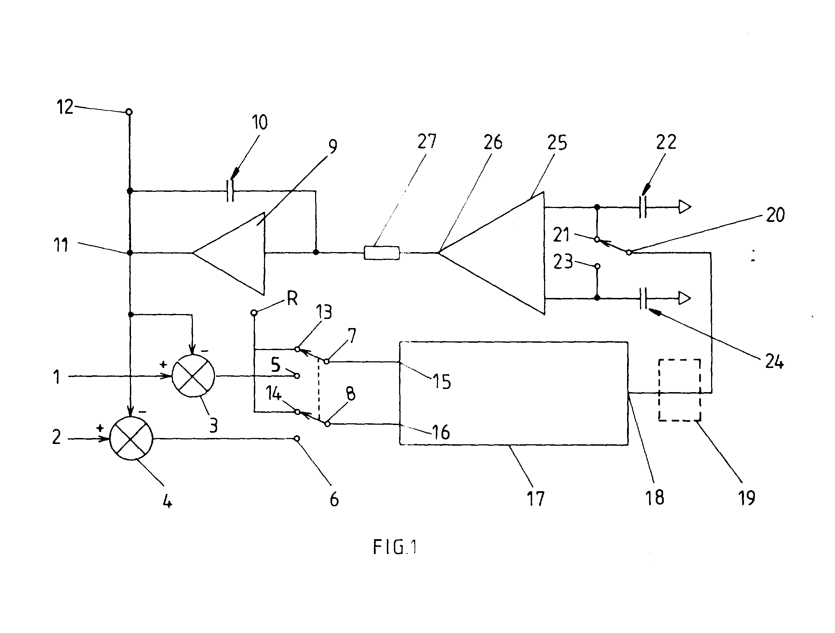

Nach Fig.1 wird eine erste und eine zweite Wechselspannung von Eingängen 1 und 2 über Summierstufen 3 und 4 den Umschaltkontakten 5 und 6 zweier Umschalter 7 und 8 zugeführt. In den Summierstufen 3 und 4 wird den Wechselspannungen 1 und 2 vom Ausgang eines Integratorverstärkers 9 mit parallelliegendem Integrationskondensator 10 die Regelgröße 11 zugeführt, die von einer Ausgangsklemme 12 zur Weiterverarbeitung, insbesondere zur Anzeige oder Registrierung, entnommen werden kann.

Die Ausgänge der Umschalter 7 und 8 sind in der dargestellten Lage über Kontakte 13 und 14 mit einer Referenzspannungsquelle R von z.B. 10 Volt verbunden. Diese Referenzspannung soll zweckmäßig größer als die Spitzenspannung der zugeführten Wechselspannungen sein.

Mit den Umschaltern 7 und 8 sind die Eingangsklemmen 15 und 16 eines Produktbildners 17 verbunden, der durch einen üblichen Momentanwert-Multiplizierer gebildet sein kann und der an seinem Ausgang 18 ein Produktsignal liefert. Von diesem wird jeweils die Gleichstromkomponente benötigt; ggf. kann dem Produktbildner 17 noch ein Mittelwertbildner, z.B. ein Filter 19 mit niedriger Grenzfrequenz, nachgeschaltet sein. Das Ausgangssignal 18 geht weiter zu einem Umschalter mit neutraler Mittelstellung, an dessen oberen Kontakt 21 gegen Masse ein Speicherkondensator 22 und an dessen unteren Kontakt 23 gegen Masse ein Speicherkondensator 24 angeschlossen sind. Die Kontakte 21 und 23 und damit die Kondensatoren 22 und 24 sind weiter an die Eingänge eines Differenzverstärkers 25 angeschlossen, von dessen Ausgang 26 die erhaltene Differenzgröße über einen Trennwiderstand 27 an den Integrationsverstärker 9,10 angeschlossen ist. Die Differenzgröße vom Ausgang 26 wird über den Integrator 9,10 in die Regelgröße 11 umgewandelt, die dann das Gleichstrom-Ausgangssignal des Produktbildners 17 auf einem, im wesentlichen von der ferenzspannung R an den Kontakten 13 und 14 bestimmten Wert hält, wobei die Regelung an einem Arbeitspunkt außerhalb von Null erfolgt.

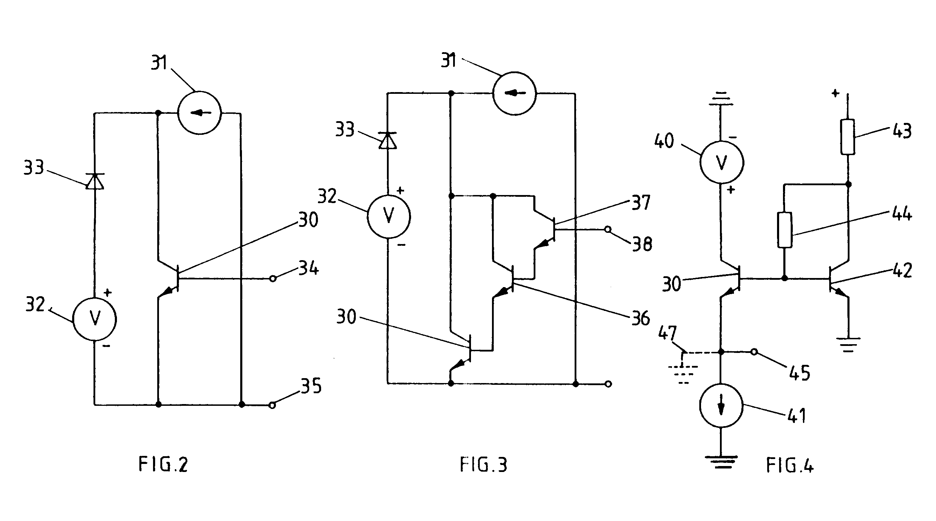

Fig. 2 zeigt eine Ausführungsform der Erfindung, bei der als Produktbildner ein Transistor 30 dient, dem von einer Stromquelle 31 ein der ersten Wechselstromgröße entsprechender Emitter-Kollektor-Strom eingeprägt wird, während mittels einer der zweiten Wechselstromgröße proportionalen Spannung 32 über eine Diode 33 eine, die Emitter-Kollektor-Spannung bestimmende Größe eingeprägt wird. Das Produkt der Größen 31 und 32 bestimmt die Erwärmung des Transistors 30. An der mit der Basis des Transistors 30 verbundenen Ausgangsklemme 34 kann gegenüber dem Emitteranschluß 35 eine von der Erwärmung des Transistors 30 abhängende Spannung entnommen werden.

Fig. 3 zeigt eine entsprechende Schaltung, bei der zwischen Basis und Kollektor des ersten Transistors 30 die Emitter Kollektor-Strecke eines dritten Transistors 36 und zwischen Basis und Kollektor des dritten Transistors 36 die Emitter-Kollektor-Strecke eines vierten Transistors 37 angeschaltet sind, wobei alle Transistoren vom gleichen npn-Leitfähigkeitstyp sind und die Ausgangsgrößen zwischer der Basis des vierten Transistors 37 von einer Ausgangsklemme 38 entnommen werden können. In Fig. 3 wirken die zusätzlichen Transistoren 36 und 37 wie Verstärker, so daß an der Ausgangsklemme 38 ein wesentlich größerer Spannungsschub auftritt als an der Klemme 34 in Fig.2.

Fig. 4 zeigt eine Ausführungsform mit dem ersten Transistor 30, dessen Kollektor geqenüber Erde an einer mit der ersten Wechselstromgröße gesteuerten Spannungsquelle 40 an Masse liegt. Sein Emitter ist über eine der zweiter Wechselstromgröße entsprechende Stromquelle 41 und somit über einen sehr hohen Widerstand ebenfalls an Masse angeschlossen. Die erforderliche Speisespannung, die eine falsche Polung des Transistors 30 verhindert, wird durch den in der Wechselspannungsquelle 40 enthaltenen Gleichspannungsanteil, der insbesondere durch die Regelgröße 11 in Fig.1 gebildet wird, gewährleistet.

Die Basis des ersten Transistors 30 ist mit der Basis eines zweiten Transistors 42 gleichen npn-Leitfähigkeitstyps verbunden, der über einen Kollektorwiderstand 43 mit einer Speisequelle von z.B. 15 V verbunden ist, wobei vom Kollektor des zweiten Transistors 42 den Basen der beiden Transistoren über einen Widerstand 44 ein Einstellstrom zugeführt wird und die Ausgangs-Gleichspannung dem Emitter des ersten Transistors 30 an der Ausgangsklemme 45 entnommen werden kann.

In Fig. 4 wird durch den zweiten Transistor 42 die Basis gegenüber Masse auf dem durch die Basis-Emitter-Diode bedingten Wert von etwa 0,7 Volt festgehalten. Entsprechend liegt auch die Ausgangsklemme 45 virtuell auf Masse, wie bei 47 gestrichelt angedeutet ist. Etwaige, durch den Transistoraufbau bedingte Abweichungen werden dadurch kompensiert und nur die zusätzlichen durch die multiplizierten Größen verursachten wärmeeinflüsse an Ausgangsklemme 45 gemessen.

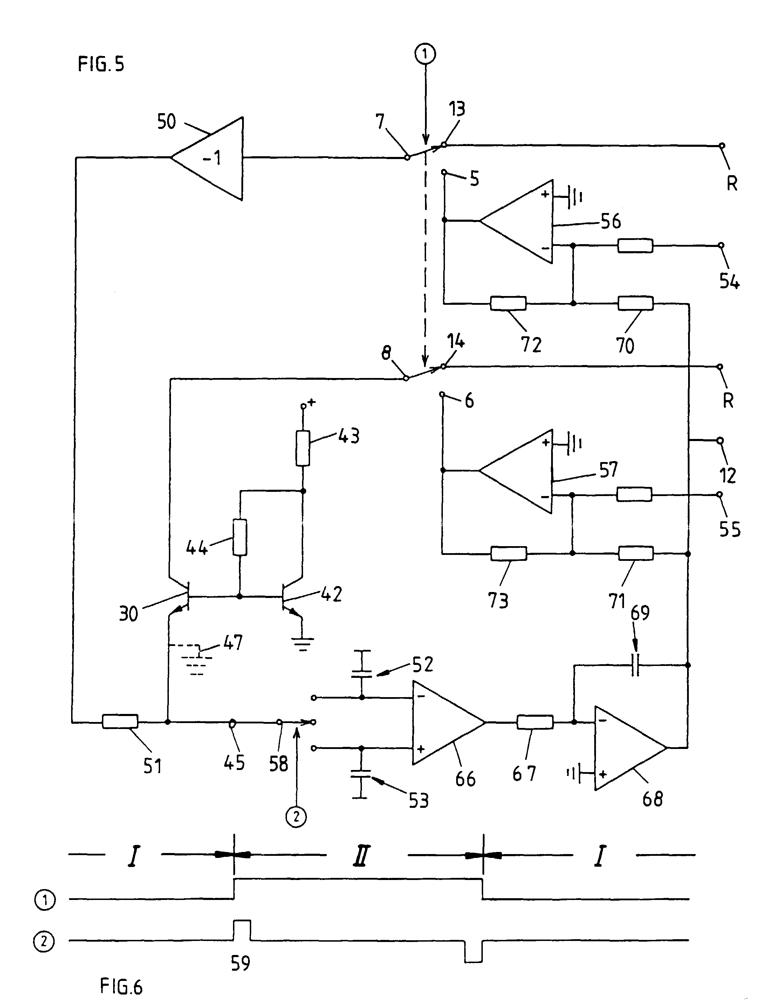

Fig. 5 zeigt ein mehr detailliertes Schaltbild mit im Intervall-Takt geschalteten, Fig.1 entsprechenden, Umschaltern 7 und 8, die in der dargestellten Lage die Ausgangsklemmen über die Kontakte 13 und 14 mit der Referenzspannung R von 10 Volt verbinden. Diese wird über einen umkehrenden Stromverstärker 50 und einen Widerstand 51 dem Emitter des ersten Transistors 30 zugeführt. Der Verstärker 50 kann auch ein einfacher Spannungs-Inverter sein, wobei die für die Stromsteuerung erforderliche Innenimpedanz vorwiegend vom Widerstand 51 bewirkt wird.

Von der mit der Eingangsklemme 14 verbundenen Ausgangsklemme des Umschalters 8 wird in der dargestellten Lage die Referenzspannung dem Kollektor des Transistors 30 zugeführt und so die Spannung an der Kollektor-Emitter-Strecke eingeprägt, da annähernd, wie vorstehend bemerkt, mittels des Transistors 42 am Emitter des Transistors 30 eine virtuelle Masse 47 hervorgerufen wird. Die so an der Ausgangsklemme 45 des Produktbildners im zweiten Intervall (II) auftretende Spannung (vgl. Fig.6, Kurve (1)) kann gemäß Fig.6, Kurve (2) am Ende dieses zweiten Intervalles (II) kurzzeitig auf einen Speicherkondensator geschaltet werden.

Im anderen, ersten Intervall I sind die Umschalter 7 und 8 mit ihren anderen Eingangsklemmen 5 bzw. 6 verbunden, an denen von den Klemmen 54 und 55 über Verstärker 56 bzw. 57 die zu multiplizierenden Wechselstromgrößen zugeführt werden. In diesem ersten Intervall, das in Fig.6 durch die die Stellung der Umschalter 7 und 8 angebenden Kurve 1 dargestellt ist, wird die Erwärmung des Transistors 30 durch die Summe des Produktes der Wechselgrößen 54 und 55 und des Quadrates der Regelgröße 11 bestimmt. Gemäß der Kurve 2 in Fig.6 wird diese Erwärmung nach Beendigung des Intervalles I entsprechend der die Stellungen eines Umschalters 58 mit Mittelstellung darstellenden Kurve 2 in Fig.6 in einem kurzen Schaltintervall auf einen Speicherkondensator 52 übertragen.

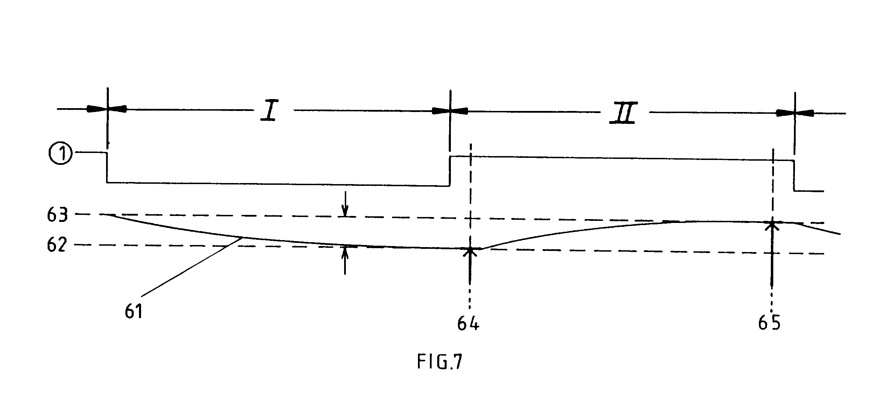

In Fig. 7 ist in der oberen Kurve wieder die Schaltkurve 1 der Umschalter 7 und 8 dargestellt, und die Kurve 61 gibt in stark vergrößertem Maße die Temperaturänderungen bzw. die entsprechende Basis-Emitter-Spannungsänderung während des ersten und des zweiten Schaltintervalles an; infolge der im Falle einer nicht exakten Ausregelung unterschiedlichen Erwärmung wird am Ende des jeweiligen Intervalles ein Grenzwert 62 bzw. 63 erreicht. Nach dem ersten Intervall I mit den Wechselstromgrößen werden, wie insbesondere Fig.6 zu entnehmen ist, zuerst die Wechselstromgrößen abgeschaltet und unmittelbar danach der Erwärmungswert (62 in Fig.7) zum Zeitpunkt 64 auf dem Kondensator 52 gespeichert. Danach wird gemäß der Kurve (1) in Fig.6 der Umschalter 7 in die andere Lage gebracht, so daß dann der Referenzwert R dem Transistor 30 zugeführt wird und die Erwärmung nach der Kurve 61 den Wert 63 annimmt. Im Zeitpunkt 65 kann, noch im Intervall II, dieser Erwärmungswert mittels des Schalters 58 abgetastet und dem Speicherkondensator 53 zugeführt werden. Die Spannungen der Speicherkondensatoren 52 und 53 werden einem Differenzverstärker 66 zugeführt, und das erhaltene Ausgangssignal steuert über einen Längswiderstand 67 einen Integrationsverstärker 68 mit dem Kondensator 69. Die so erhaltene Regelspannung kann einerseits einer Ausgangsklemme 12 entnommen werden und wird andererseits zur Kombination mit den Wechselstromgrößen 54 und 55 über Längswiderstände 70 und 71 den Eingängen der Verstärker 56 bzw. 57 zugeführt, wobei außerdem über Widerstände 72 und 73 in üblicher Weise eine Gegenkopplung erfolgt. An den Klemmen 5 und 6 stehen somit die Wechselspannungen einschließlich der erzeugten Regelspannung zur Verfügung. Durch diese Steuerung und Regelung wird erreicht, daß die Ausgangsspannung des Produktbildners 30,42 an der Klemme 45 unabhängig von der Amplitude der Wechselstromgrößen konstant gehalten wird und an der Ausgangsklemme 12 ein dem Produkt, z.B. der Leistung, proportionales Meßsignal erhalten werden kann.

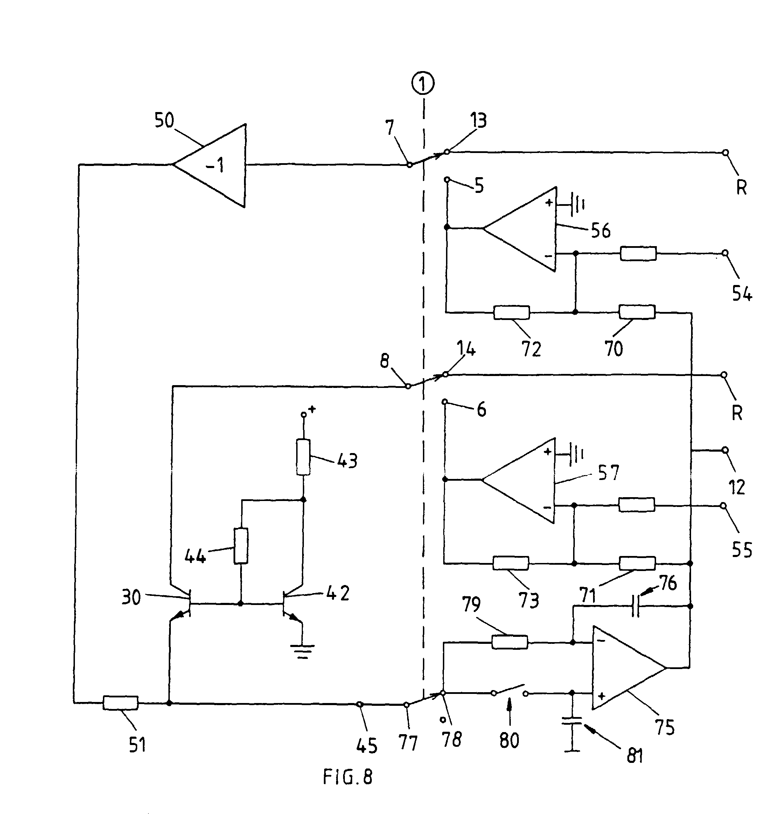

Fig. 8 zeigt eine Abwandlung der Schaltung nach Fig.5, wobei gleiche Schaltelemente gleiche Bezugszeichen tragen.

Die Änderung besteht darin, daß anstelle eines Differenzverstärkers 66 mit nachgeschaltetem Integrator 68,69 ein Differential-Integrator 75 mit Kondensator 76 Verwendung findet. Das Ausgangssignal von der Klemme 45 des Produktbildners wird einem Schalter 77 zugeführt, der im ersten Intervall geöffnet und im zweiten Intervall mit seiner Ausgangsklemme 78 verbunden ist, die über einen Widerstand 79 an dem -Eingang des Differential-Integrators 75 angeschaltet ist. Die Klemme 78 ist weiter über einen Schalter 80 an einen Speicherkondensator 81 von z.B. 1 uF angeschlossen. Der Schalter 80 wird entsprechend dem in Fig. 6 bei 59 dargestellten Kurvenzug unmittelbar am Anfang des zweiten Intervalles kurzzeitig geschlossen, so daß die Ausgangsgröße von der Klemme 45 entsprechend dem im Wechselstromintervall I erhaltenen Erwärmungswert auf dem Kondensator 81 gespeichert wird. Der während des Referenz-Intervalles II auftretende Wert wird über den Widerstand 79 direkt dem -Eingang des Differential-Integrators 75 während des ganzen zweiten Intervalles II zugeführt.

Der Kondensator 81 liegt einerseits an Erde und andererseits an dem +Eingang des Differential-Integrators 75. Somit werden die aus der Erwärmung des Transistors 30 abgeleiteten Werte in Differenz am Integrator 75 wirksam gemacht und liefern die Regelspannung, die auch an der Klemme 12 das Ausgangssignal bildet.

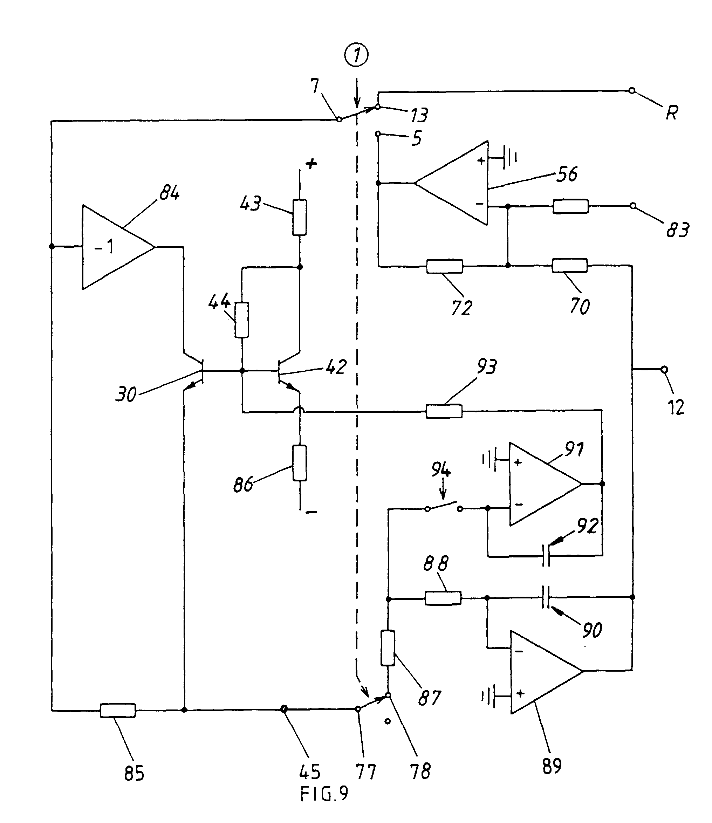

In Fig. 9 ist eine Variante dargestellt, mit der eine einzige Wechselspannung 83 quadriert werden kann. Gegenüber Fig.8 gleichartige Schaltelemente sind dabei mit gleichen Bezugszeichen bezeichnet.

In der dargestellten Lage des Schalters 7 im zweiten Intervall ist die Referenzspannung R mit dem Eingang eines Umkehrverstärkers 84 verbunden. Dieser liefert eine feste Elektrodenspannung für den ersten Transistor 30. Außerdem führt die Spannung vom Umschalter 7 über einen Vorwiderstand 85 z.B. 1 kOhm zu einem einprägenden Strom in die Emitter-Kollektor-Strecke des Transistors 30; dessen Erwärmungsleistung ist somit vom Quadrat der zugeführten Spannung abhängig. Der über die verbundenen Basen angeschlossene zweite Transistor 42 ist einerseits über einen Widerstand 43 an eine Speisespannung "+" von 15 Volt und über einen etwa gleichen Emitterwiderstand 86 an eine negative Speisespannung "-" von z.B. -15 Volt angeschlossen. Bei etwa gleichen Kollektor- und Emitterwiderständen 43,86 liegt der Emitter des Transistors 42 etwa auf Masse, was dann auch für den Emitter des Transistors 30 und die Ausgangsklemme 45 gilt. Die im zweiten Intervall durch die Referenzspannung erhaltene Ausgangsgröße von der Klemme 45 wird über einen Widerstand 87 und einen Widerstand 88 der -Eingangsklemme eines ersten Integrators 89 mit Kondensator 90 zugeführt, der die erzeugte erste Regelspannung über den Widerstand 70 dem Differenzverstärker 56 zuführt. Über einen entsprechend der Kurve 2 in Fig.6 im Intervall 59 gesteuerten Schalter 94 wird am Anfang des zweiten Intervalles der im ersten Intervall entstandene Ausgangswert von der Klemme 45 dem -Eingang des zweiten Integrators 91 mit Kondensator 92 zugeführt und von dessen Ausgang über einen Widerstand 93 an die Basen der Transistoren 30 und 42 übertragen. Dadurch wird dann auch das Emitterpotential dieser Transistoren entsprechend der durch die Wechselstromgröße bewirkten Erwärmung verschoben, und eine sofortige Nachregelung im zweiten Intervall unter dem Einfluß der zugeführten Referenzspannung tritt ein. Durch diese Anordnung wird der Ermitter vom Transistor 30 exakt auf virtuelle Masse ausgeregelt (wie Fig.5 die virtuelle Masse 47).

### Bezugszeichenliste:

- 1,2: Wechselspannungen
- 3,4: Summierstufen
- 5,6: Umschaltkontakte
- 7,8: Umschalter
- 9: Integratorverstärker
- 10: Kondensator
- 11: Regelgröße
- 12: Ausgang
- 13,14: Referenz-Umschalterkontakte
- 15,16: Eingangsklemmen
- 17: Produktbildner
- 18: Ausgang
- 19: Mittelwertbildner
- 20: Umschalter
- 21: oberer Umschalterkontakt
- 22: Speicherkondensator
- 23: unterer Umschalterkontakt
- 24: Speicherkondensator
- 25: Differenzverstärker
- 26: Ausgang
- 27: Trennwiderstand
- 30: erster Transistor
- 31: Stromquelle
- 32: Spannungsquelle
- 33: Diode
- 34: Ausgangsklemme
- 35: Emitteranschluß
- 36: dritter Transistor
- 37: vierter Transistor
- 38: Ausgangsklemme
- 40: Wechselspannungsquelle
- 41: Stromquelle
- 42: zweiter Transistor
- 43: Kollektorwiderstand
- 44: Kollektor-Basis-Widerstand
- 45: Ausgangsklemme
- 47: virtuelle Masse
- 50: Umkehrverstärker
- 52,53: Speicherkondensatoren
- 54,55: Wechselstromeingang
- 56,57: Verstärker
- 58: Umschalter mit Mittelstellung
- 59: Schaltintervall
- 61: Erwärmungskurve
- 62,63: Erwärmungswert
- 64,65: Schaltzeitpunkte
- 66: Differenzverstärker
- 67: Längswiderstand
- 68: Integrationsverstärker
- 69: Kondensator
- 70,71: Widerstände
- 72,73: Gegenkopplungswiderstände
- 75: Differentialintegrator
- 76: Kondensator
- 77: Schalter
- 78: Ausgangsklemme
- 79: Widerstand
- 80: Schalter
- 81: Speicherkondensator
- 83: Wechselspannung
- 84: Umkehrverstärker
- 85: Vorwiderstand
- 86: Emitterwiderstand
- 87,88: Widerstand
- 89: erster Integrator
- 90: Kondensator
- 91: zweiter Integrator
- 92: Kondensator
- 93: Widerstand
- 94: Schalter

## Patentansprüche

1. Schaltungsanordnung zum Messen des zeitlichen Mittelwertes des Produktes zweier Wechselstromgrössen (1, 2) bzw. des Quadrates einer Wechselstromgrösse, derart aufgebaut, dass ein Produktbildner (17) vorhanden ist, an dessen Ausgang (18, 34, 38, 45) ein Gleichstrom-Ausgangssignal ansteht, und dessen Ausgang (18, 34, 38, 45) zur Bildung einer Regelgrösse (11) für die Konstanthaltung des Arbeitspunktes des Produktbildners (17) mit einem Integrator (9, 10; 68, 69; 75, 76; 89, 90) in Verbindung steht, dass dem Produktbildner (17) über einen ersten und ggf. einen zweiten Intervallschalter (7 bzw. 8) und eine erste und ggf. eine zweite Summierstufe (3 bzw. 4; 56 bzw. 57) abwechselnd in einem ersten Zeitintervall (I) die Summe aus der regelgrösse (11) und wenigstens einer Wechselstromgrösse (1, 2) zugeführt wird, aus welcher der Produktbildner (17) ein erstes Gleichstrom-Ausgangssignal bildet, dass in einem zweiten Intervall (II) dem Produktbildner (17) eine GleichstromReferenzgrösse (R) zugeführt wird, aus welcher der Produktbildner (17) ein zweites Gleichstrom-Ausgangssignal bildet, dass dem Produktbildner (17) Mittel (25, 66, 75) zur Bildung der Differenz beider Gleichstrom-Ausgangssignale nachgeschaltet sind, die mit dem Integrator (9, 10; 68, 69; 75, 76; 89, 90) zur Bildung der Regelgrösse verbunden sind, derart, dass die genannte Differenz auf Null geregelt wird und der Arbeitspunkt des Produktbildners (17) im ersten und im zweiten Intervall (I, II) wenigstens annähernd gleich gehalten wird, und dass ein Ausgang (12) vorhanden ist, an welchem die Regelgrösse (11) als Mass für den zeitlichen Mittelwert des Produktes der Wechselstromgrössen abgreifbar ist.

2. Schaltungsanordnung nach Anspruch 1,
dadurch gekennzeichnet,
dass Mittel (22, 24; 52, 53; 81) zur Speicherung der Gleichstrom-Ausgangssignale vorhanden sind.

3. Schaltungsanordnung nach Anspruch 2,
dadurch gekennzeichnet,
dass die Mittel zur Speicherung Speicherkondensatoren (22, 24; 52, 53; 81) umfassen, welche über wenigstens einen Ausgangs-Schalter (20, 58, 77) mit dem Ausgang (18, 45) des Produktbildners (17) verbindbar sind, und dass die Mittel zur Bildung der Differenz der Gleichstrom-Ausgangssignale einen Differenzverstärkers (25, 66, 75) umfassen, an dessen Eingänge die Speicherkondensatoren (22, 24; 52, 53; 81) angeschlossen sind.

4. Schaltungsanordnung nach einem der vorangegangenen Ansprüche,
dadurch gekennzeichnet,
dass die Länge der Intervalle eine Mehrzahl von Wechselstromperioden, z.B. 3 bis 20, vorzugsweise 10 Wechselstromperioden, umfasst.

5. Schaltungsanordnung nach Anspruch 3 oder 4,
dadurch gekennzeichnet,
dass der bzw. die Ausgangs-Schalter (20, 58, 77) nur kurzzeitig am Ende jedes Intervalles geschlossen wird/werden.

6. Schaltungsanordnung nach Anspruch 3 oder 4,
dadurch gekennzeichnet,
dass der bzw. die Ausgangs-Schalter (20, 58, 77) nur kurzzeitig am Anfang und am Ende des zweiten Intervalles geschlossen wird/werden.

7. Schaltungsanordnung nach einem der vorangegangenen An' sprüche,
dadurch gekennzeichnet,
dass als Produktbildner (17) wenigstens ein Bauelement (30, 36, 37, 42) dient, das entsprechend dem Produkt der zugeführten Wechselstromgrössen erwärmt wird und ein Ausgangssignal abgibt, welches von der damit verbundenen Temperaturerhöhung abhängt.

8. Schaltungsanordnung nach Anspruch 7,
dadurch gekennzeichnet,
dass der Produktbildner (17) wenigstens einen ersten Transistor (30) umfasst, dass zwischen dem Kollektor und dem Emitter des ersten Transistors (30) eine Stromquelle (31) angeordnet ist, deren Strom einerseits im ersten Intervall (I) in Abhängigkeit von den mit der Regelgrösse kombinierten Wechselstromgrössen bzw. im zweiten Intervall von der Referenzgrösse (R) gesteuert wird, dass zwischen Kollektor und Emitter des ersten Transistors (30) eine Spannungsquelle (32) angeordnet ist, deren Spannung andererseits im ersten Intervall (I) in Abhängigkeit von den mit der Regelgrösse kombinierten Wechselstromgrössen bzw. im zweiten Intervall von der Referenzgrösse (R) gesteuert wird, und dass die Basis-Emitter-Spannung des ersten Transistors (30) das erste bzw. das zweite Gleichstrom-Ausgangssignal liefert (Fig. 2).

9. Schaltungsanordnung nach Anspruch 7,
dadurch gekennzeichnet,
dass der Produktbildner (17) wenigstens einen ersten Transistor (30) umfasst, dessen Emitter-Kollektor-Strom und dessen Emitter-Kollektor-Spannung im erster Intervall (I) in Abhängigkeit von der mit der Regelgröße kombinierten ersten bzw. zweiten Wechselstromgröße und im zweiten Intervall (II) von der Referenzgröße (R) gesteuert werden, und dass die Basis des ersten Transistors (30) mit der Basis eines zweiten Transistors (42) gleichen Leitfähigkeitstyps verbunden ist, der über einen Kollektorwiderstand (43) mit einer ersten Speisequelle (+) und ggf. über einen Emitterwiderstand mit einer zweiten Speisequelle (-) verbunden ist, wobei vom Kollektor des zweiten Transistors (42) den Basen über einen Widerstand (44) ein Einstellstrom zugeführt wird, und das Gleichstrom-Ausgangssignal am Emitter des ersten Transistors (30) ansteht (Fig. 4,9).

10. Schaltungsanordnung nach Anspruch 7,
dadurch gekennzeichnet,
dass der Produktbildner (17) wenigstens einen ersten Transistor (30) umfasst, dass zwischen dem Kollektor und dem Emitter des ersten Transistors (30) eine Stromquelle (31) angeordnet ist, deren Strom einerseits im ersten Intervall (I) in Abhängigkeit von den mit der Regelgrösse kombinierten Wechselstromgrössen bzw. im zweiten Intervall von der Referenzgrösse (R) gesteuert wird, dass zwischen Kollektor und Emitter des ersten Transistors (30) eine Spannungsquelle (32) angeordnet ist, deren Spannung andererseits im ersten Intervall (I) in Abhängigkeit von den mit der Regelgrösse kombinierten Wechselstromgrössen bzw. im zweiten Intervall von der Referenzgrösse (R) gesteuert wird, dass zwischen Basis und Kollektor des ersten Transistors (30) die Emitter-Kollektor-Strecke eines dritten Transistors (36) und zwischen Basis und Kollektor des dritten Transistors (36) die Emitter-Kollektor-Strecke eines vierten Transistors (37) angeordnet ist, wobei alle Transistoren (30, 36, 37) vom gleichen Leitfähigkeitstyp sind, und dass die Gleichstrom-Ausgangsgrössen zwischen der Basis des vierten Transistors (37) und dem Emitter des ersten Transistors (30) anstehen (Fig. 3).

11. Schaltungsanordnung nach Anspruch 9,
dadurch gekennzeichnet,
dass die im zweiten Intervall aus der Referenzgrösse (R) gewonnene Ausgangsgrösse über ein Halteglied dem zweiten Transistor (42) an der Basis oder am Emitter zugeführt wird.

12. Schaltungsanordnung nach einem der vorangegangenen Ansprüche,
dadurch gekennzeichnet,
daß die Regelgröße (11) mit der ersten und gegebenenfalls der zweiten Wechselstromgröße jeweils am Eingang eines Verstärkers (56 bzw. 57) kombiniert wird, dessen Ausgang mit einem Eingang (5 bzw. 6) des ersten bzw. gegebenenfalls des zweiten Intervallschalters (7 bzw. 8) verbunden ist.

13. Schaltungsanordnung nach einem der Ansprüche 1 und 2,
dadurch gekennzeichnet,
dass die Gleichstrom-Ausgangssignale des Produktbildners (17) dem einen Eingang eines Differenzverstärker-Integrators (75) zugeführt werden, an dessen anderem Eingang ein Speicherkondensator (81) liegt, der am Anfang des zweiten Intervalls (II) mittels eines Schalters (80) kurzzeitig mit dem Ausgang des Produktbildners (17) verbunden wird.

14. Schaltungsanordnung nach Anspruch 13,
dadurch gekennzeichnet,
dass die Gleichstrom-Ausgangssignale des Produktbildners (17) über einen dritten Intervall-Schalter (77) dem Differenzverstärker-Integrator (75) nur für die Dauer des zweiten Intervalles (II) zugeführt werden.

15. Schaltungsanordnung nach Anspruch 9,
dadurch gekennzeichnet,
dass zum Quadrieren einer Wechselstromgrösse (83) diese kombiniert mit der Regelgröße, im ersten Intervall (I) sowohl den Emitter-Kollektor-Strom als auch die Emitter-Kollektor-Spannung des ersten Transistors (30) steuert.

16. Schaltungsanordnung nach Anspruch 15 in Verbindung mit einem der Ansprüche 1, 2, 4, 5 oder 6,
dadurch gekennzeichnet,
dass der Integrator aus zwei Teil-Integratoren (89, 91) besteht, wobei der erste Teil-Integrator (89) während des ganzen zweiten Intervalles (II) angeschaltet ist, und sein Ausgang mit dem Ausgang (12) für die Regelgrösse (11) verbunden ist, und wobei der zweite Teil-Integrator (91) über einen Schalter (94) nur am Anfang des zweiten Intervalles (II) angeschaltet ist, und sein Ausgang mit der Basis-Emitter-Steuerstrecke des zweiten Transistors (42) verbunden ist.

17. Schaltungsanordnung nach Anspruch 16,
dadurch gekennzeichnet,
dass der Ausganq des zweiten Teil-Inteqrators (91) mit den verbundenen Basen des ersten und des zweiten Transistors (30 bzw. 42) verbunden ist.

## Claims

1. Circuit arrangement for measuring the temporal mean value of the product of two alternating current values (1, 2) or of the square of an alternating current value, constituted in such a way that a product former (17) is provided, at whose output (18, 34, 38, 45) a direct-current output signal is waiting and whose output (18, 34, 38, 45) is connected to an integrator (9,10; 68,69; 75,76; 89,90) for the formation of a controlled variable (11) for maintaining the constancy of the operating point of the product former (17), in that, to the product former (17), via a first and possibly a second interval switch (7 or 8) and a first and possibly a second mixing stage (3 or 4; 56 or 57), alternately in a first time interval (I), the sum of the controlled variable and at least of one alternating-current value (1, 2) is supplied, from which the product former (17) generates a first direct-current output signal, in that, in a second interval (II), a direct-current reference variable (R) is supplied to the product former (17), from which the product former (17) generates a second direct-current output signal, in that means (25, 66, 75) for the formation of the difference of both direct-current output signals are mounted behind the product former (17), which are connected to the integrator (9,10; 68,69; 75,76; 89,90) for the formation of the controlled variable in such a way that the stated difference is controlled to zero and the operating point of the product former (17), in the first and in the second interval (I,II) is kept at least approximately equal and in that an output (12) is provided, at which the controlled variable (11) can be tapped as measure of the temporal mean value of the product of the alternating-current values.

2. Circuit arrangement according to Claim 1,
characterized in that
the means (22,24; 52,53; 81) for storing the direct-current output signals exist.

3. Circuit arrangement according to Claim 2,
characterized in that
the means for the storage comprise storage capacitors (22,24; 52,53; 81) which, via at least one output switch (20, 58, 77) are connectable to the output (18, 45) of the product former (17), and in that the means for forming the difference of the direct-current output signals comprise a differential amplifier (25, 66, 75), to whose inputs the storage capacitors (22,24; 52,53; 81) are connected.

4. Circuit arrangement according to any of the preceding claims,
characterized in that
the length of the intervals comprises a plurality of alternating-current cycles, e.g. 3 to 20, by preference 10 alternating-current cycles.

5. Circuit arrangement according to either Claim 3 or 4,
characterized in that
the output switch or switches (20, 58, 77) is/are closed only for a short time at the end of each interval.

6. Circuit arrangement according to either Claim 3 or 4,
characterized in that
the output switch or switches (20, 58, 77) is/are closed only for a short time at the beginning and at the end of the second interval.

7. Circuit arrangement according to any of the preceding claims,
characterized in that,
as product former (17), at least one component (30, 36, 37, 42) serves which, according to the product of the alternating-current value supplied, is heated and emits an output signal, which depends on the temperature increases connected therewith.

8. Circuit arrangement according to Claim 7,
characterized in that
the product former (17) comprises at least one first transistor (30), in that, between the collector and the emitter of the first transistor (30), a current source (31) is disposed, whose current, on the one hand, in the first interval (I), is controlled in dependence of the alternate-current values combined with the controlled variable or, in the second interval, by the reference variable (R), in that, between the collector and the emitter of the first transistor (30), a voltage source (32) is disposed, whose voltage, on the other hand, is controlled in the first interval (I) in dependence of the alternating-current values combined with the controlled variable or, in the second interval (II), is controlled by the reference variable (R) and in that the base-emitter voltage of thefirst transistor (30) supplies the first or the second direct-current output signal (Fig.2).

9. Circuit arrangement according to Claim 7,
characterized in that
the product former (17) comprises at least one first transistor (30), whose emitter-collector current and whose emitter-collector voltage, in the first interval (I), are controlled in dependence of the first or the second alternating-current value combined with the controlled variable and, in the second interval (II), by the reference variable (R), and in that the base of the first transistor (30) is connected to the base of a second transistor (42) of the same conductivity type which, via a collector resistance (43), is connected to a supply (+) and, possibly, via an emitter resistance, to a second supply (-), in which case, from the collector of the second transistor (42), an adjusting current is supplied to the bases via a resistor (44) and in that the direct-current output signal is waiting at the emitter of the first transistor (39) (Fig.9).

10. Circuit arrangement according to Claim 7,
characterized in that
the product former (17) cmprises at least one first transistor (30), in that the product former (17) comprises at least one first transistor (30), in that, between the collector and the emitter of the first transistor (30), a current source (31) is disposed, whose current, on the one hand, is controlled in the first interval (I) in dependence of the alternating-current values combined with the controlled variable or, in the second interval (II), by the reference variable (R), in that, between the collector and the emitter of the first transistor (30), a voltage source (32) is disposed, whose voltage, on the other hand, is controlled in the first interval (I) in dependence of the alternating-current values combined with the controlled variable or, in the second interval, by the reference variable (R), in that, between the base and the collector of the first transistor (39), the emitter-collector path of a third transistor (36) and between the base and the collector of the third transistor (36), the emitter-collector path of a fourth transistor (37) is disposed, in which case all transistors (30, 36, 37) are of the same conductivity type and in that the direct-current output values are impending between the base of the fourth transistor (37) and the emitter of the first transistor (30) (Fig.3).

11. Circuit arrangement according to Claim 9,
characterized in that
the output value gained in the second interval from the reference variable (R) is supplied via a holding element to the second transistor (42) at the base or at the emitter.

12. Circuit arrangement according to any of the preceding claims,
characterized in that
the controlled variable (11) is combined with the first and possibly the second alternating-current value in each caset the input of an amplifier (56 or 57), whose output is connected with an input (5 or 6) of the first or, possibly, of the second interval switch (7 or 8).

13. Circuit arrangement according to either Claim 1 or 2,
characterized in that
the direct-current output signals of the product former (17) are supplied to the one input of a differential amplifier integrator (75), at whose other input a storage capacitor (81) is located which, at the beginning of the second interval (II), is for a short time connected to the output of the product former (17) with the aid of a switch (80).

14. Circuit arrangement according to Claim 13,
characterized in that
the direct-current output signals of the product former (17) are, via a third interval switch (77), supplied to the differential integrator (75) only for the duration of the second interval (II).

15. Circuit arrangement according to Claim 9,
characterized in that,
for the squaring of an alternating-current value (83), the same combined with the controlled variable in the fist interval (I), controls both the emitter-collector current as well as the emitter-collector voltage of the first transistor (30).

16. Circuit arrangement according to Claim 15 in connection with any of Claims 1, 2, 4, 5 or 6,
characterized in that
the integrator is comprised of two subintegrators (89, 91), wherein the first subintegrator (89) is switched on during the entire second interval (II) and its output is connected to the output (12) of the controlled variable (11), and wherein the second subintegrator (91) is switched on via a switch (94) only at the beginning of the second interval (II) and its output is connected to the base-emitter control path of the second transistor (42)

17. Circuit arrangement according to Claim 16,
characterized in that
the output of the second subintegrator (91) is connected to the interconnected bases of the first and the second transistors (30 or 42).

## Revendications

1. Montage pour mesurer la moyenne temporelle du produit de deux grandeurs alternatives (1, 2) ou du carré d'une grandeur alternative, constitué de telle manière qu'il existe un formateur de produit (17) à la sortie (18, 34, 38, 45) duquel se trouve un signal de sortie continu et dont la sortie (18, 34, 38, 45) est en relation, pour former une grandeur réglée (11) pour le maintien constant du point de fonctionnement dynamique du formateur de produit (17), avec un intégrateur (9, 10 ; 68, 69 ; 75, 76 ; 89, 90), que la somme de la grandeur réglée (11) et d'au moins une grandeur alternative (1, 2) est amenée au formateur de produit (17) par l'intermédiaire d'un premier et, le cas échéant, d'un second commutateur à intervalle (7 et 8) et d'un premier et, le cas échéant, d'un second étage additionneur (3 et 4 ; 56 et 57) en alternance dans un premier intervalle de temps (I), somme à partir de laquelle le formateur de produit (17) forme un premier signal de sortie continu, qu'une grandeur de référence continue (R) est amenée dans un second intervalle (II) au formateur de produit (17), grandeur de référence à partir de laquelle le formateur de produit (17) forme un second signal de sortie continu, que des signaux de sortie continus sont intercalés à la suite du formateur de produit (17) pour former la différence des deux signaux de sortie continus qui sont reliés avec l'intégrateur (9, 10 ; 68, 69 ; 75, 76 ; 89, 90) pour former la grandeur réglée, de telle manière que la différence citée est réglée à zéro et le point de fonctionnement dynamique du formateur de produit (17) dans le premier et dans le second intervalle (I, Il) est maintenu au moins approximativement égal et qu'il existe une sortie (12) à laquelle la grandeur réglée (11) peut être prise comme mesure pour la moyenne temporelle du produit des grandeurs alternatives.

2. Montage selon la revendication 1,
**caractérisé en ce**
qu'il existe des moyens (22, 24 ; 52, 53 ; 81) pour mémoriser les signaux de sortie continus.

3. Montage selon la revendication 2,
**caractérisé en ce**
que les moyens pour mémoriser comprennent des condensateurs à mémoire (22, 24 ; 52, 53 ; 81) qui peuvent être reliés par au moins un commutateur de sortie (20, 58, 77) à la sortie (18, 45) du formateur de produit (17) et que les moyens pour former la différence des signaux de sortie continus comprennent un amplificateur différentiel (25, 66, 75) aux entrées duquel les condensateurs à mémoire (22, 24 ; 52, 53 ; 81) sont raccordés.

4. Montage selon l'une des revendications précédentes,
**caractérisé en ce**
que la longueur des intervalles comprend une multitude de périodes de courant alternatif, par exemple 3 à 20, de préférence 10 périodes de courant alternatif.

5. Montage selon la revendication 3 ou 4,
**caractérisé en ce**
que le ou les commutateurs de sortie (20, 58, 77) n'est/ne sont fermé(s) que temporairement à la fin de chaque intervalle.

6. Montage selon la revendication 3 ou 4,
**caractérisé en ce**
que le ou les commutateurs de sortie (20, 58, 77) n'est/ne sont fermé(s) qu'au début et à la fin du second intervalle.

7. Montage selon l'une des revendications précédentes,
**caractérisé en ce**
qu'au moins un composant (30, 36, 37, 42) sert de formateur de produit (17), composant qui est réchauffé conformément au produit des grandeurs alternatives amenées et qui donne un signal de sortie qui dépend de l'augmentation de température qui est liée à ceci.

8. Montage selon la revendication 7,
**caractérisé en ce**
que le formateur de produit (17) comprend au moins un premier transistor (30), qu'une source de courant (31) est placée entre le collecteur et l'émetteur du premier transistor (30), source dont le courant est commandé d'une part dans le premier intervalle (I) en fonction des grandeurs alternatives combinées à la grandeur réglée ou dans le second intervalle par la grandeur de référence (R), qu'une source de tension (32) est placée entre le collecteur et l'émetteur du premier transistor (30), source dont la tension est commandée d'autre part dans le premier intervalle (I) en fonction des grandeurs alternatives combinées à la grandeur réglée ou dans le second intervalle par la grandeur de référence (R) et que la tension base-émetteur du premier transistor (30) donne le premier ou le second signal de sortie continu (figure 3).

9. Montage selon la revendication 3,
**caractérisé en ce**
que le formateur de produit (17) comprend au moins un premier transistor (30) dont le courant émetteur-collecteur et dont la tension émetteur-collecteur dans le premier intervalle (I) sont commandés en fonction de la première ou de la seconde grandeur alternative combinée à la grandeur réglée et dans le second intervalle (II) par la grandeur de référence (R) et que la base du premier transistor (30) est reliée à la base d'un second transistor (42) de même type de conductivité qui est relié, par une résistance de collecteur (43), à une première source d'alimentation (+) et, le cas échéant, par une résistance d'émetteur à une seconde source d'alimentation (-), un courant de réglage étant amené par le collecteur du second transistor (42) aux bases par l'intermédiaire d'une résistance (44), et le signal de sortie continu se trouve à l'émetteur du premier transistor (30) (figures 4, 9).

10. Montage selon la revendication 7,
**caractérisé en ce**
que le formateur de produit (17) comprend au moins un premier transistor (30), qu'une source de courant (31) est placée entre le collecteur et l'émetteur du premier transistor (30), source dont le courant est commandé d'une part dans le premier intervalle (I) en fonction des grandeurs alternatives combinées à la grandeur réglée ou dans le second intervalle par la grandeur de référence (R), qu'une source de tension (32) est placée entre le collecteur et l'émetteur du premier transistor (30), source dont la tension est commandée d'autre part dans le premier intervalle (I) en fonction des grandeurs alternatives combinées à la grandeur réglée ou dans le second intervalle par la grandeur de référence (R), que le trajet émetteur-collecteur d'un troisième transistor (36) est placé entre la base et le collecteur du premier transistor (30) et le trajet émetteur-collecteur d'un quatrième transistor (37) entre la base et le collecteur du troisième transistor (36), tous les transistors (30, 36, 37) étant du même type de conductivité, et que les grandeurs de sortie continues se trouvent entre la base du quatrième transistor (37) et l'émetteur du premier transistor (30) (figure 3).

11. Montage selon la revendication 9,
**caractérisé en ce**
que la grandeur de sortie obtenue dans le second intervalle à partir de la grandeur de référence (R) est amenée par un élément d'entretien au second transistor (42) à la base ou à l'émetteur.

12. Montage selon l'une des revendications précédentes,
**caractérisé en ce**
que la grandeur réglée (11) est combinée à la première grandeur alternative et, le cas échéant, à la seconde grandeur alternative respectivement à l'entrée d'un amplificateur (56 ou 57) dont la sortie est reliée à une entrée (5 ou 6) du premier ou, le cas échéant, du second commutateur à intervalle (7 ou 8).

13. Montage selon l'une des revendications 1 et 2,
**caractérisé en ce**
que les signaux de sortie continus du formateur de produit (17) sont amenés à l'une des entrées d'un intégrateur à amplificateur différentiel (75) à l'autre entrée duquel se trouve un condensateur à mémoire (81) qui est relié au début du second intervalle (II) au moyen d'un commutateur (80) temporairement à la sortie du formateur de produit (17).

14. Montage selon la revendication 13,
**caractérisé en ce**
que les signaux de sortie continus du formateur de produit (17) sont amenés par l'intermédiaire d'un troisième commutateur à intervalle (77) à l'intégrateur à amplificateur différentiel (75) seulement pour la durée du second intervalle (II).

15. Montage selon la revendication 9,
**caractérisé en ce**
que, pour former le carré d'une grandeur alternative (83), celle-ci, combinée à la grandeur réglée, commande le courant émetteur-collecteur aussi bien que la tension émetteur-collecteur du premier transistor (30).

16. Montage selon la revendication 15 en relation avec l'une des revendications 1, 2, 4, 5 ou 6,
**caractérisé en ce**
que l'intégrateur est constitué par deux intégrateurs partiels (89, 91), le premier intégrateur partiel (89) étant connecté pendant tout le second intervalle (II) et sa sortie étant reliée à la sortie (12) pour la grandeur réglée (11), et le second intégrateur partiel (91) étant connecté par un commutateur (94) seulement au début du second intervalle (II) et sa sortie étant reliée au trajet de commande base-émetteur du second transistor (42).

17. Montage selon la revendication 16,
**caractérisé en ce**
que la sortie du second intégrateur partiel (91) est reliée aux bases reliées du premier et du second transistor (30 et 42).
